Europäisches Patentamt

European Patent Office

Office européen des brevets

(19)

(11) Publication number: **0 082 001**
A1

(12) # EUROPEAN PATENT APPLICATION

(21) Application number: **82306627.9**

(22) Date of filing: **13.12.82**

(51) Int. Cl.³: **C 23 C 13/08**, C 23 C 13/10, C 23 C 13/02

(30) Priority: **16.12.81 GB 8137946**

(43) Date of publication of application: **22.06.83**
Bulletin 83/25

(84) Designated Contracting States: **DE FR GB IT**

(71) Applicant: **GENERAL ENGINEERING RADCLIFFE 1979 LIMITED, Bury Road, Radcliffe Manchester, M26 9UR (GB)**

(72) Inventor: **Sugden, George Barry, 96 Rudgwick Drive, Bury Lancashire (GB)**
Inventor: **Downs, John, 8 Sunningale Avenue, Radcliffe Manchester (GB)**

(74) Representative: **Downey, William Gerrard et al, WILSON GUNN & ELLIS 41 Royal Exchange Cross Street, Manchester M2 7BD (GB)**

(54) **Apparatus for and a method of metallising a length of material.**

(57) Apparatus for metallising a web W comprises a vacuum chamber 1 housing an aluminium vapour source 2 adjacent a driven water cooled process drum 5. During metallising oxygen is fed to the chamber through an inlet 7 controlled by a needle valve whilst the web is drawn over the surface of the drum in order to produce a desired surface appearance or other optical effect on the web. The appearance or optical effect can be varied by varying the position at which oxygen is introduced to the chamber.

EP 0 082 001 A1

-1-

APPARATUS FOR AND A METHOD OF

METALLISING A LENGTH OF MATERIAL.

The present invention relates to apparatus for and a method of metallising a length of material.

Where a coloured surface appearance to the metallised surface is required the metal coating which is normally aluminium is lacquered. This additional operation step is time consuming and expensive.

According to one aspect of the present invention, there is provided apparatus for metallising a length of material comprising a vacuum chamber housing supply means for the supply of the length of material to be metallised, a source for the production of evaporated aluminium and take-up means for receiving the length of metallised material, the vacuum chamber being provided with means enabling oxygen to be introduced thereto during the metallising process.

A preferred embodiment of the invention may comprise any one or more of the following advantageous features:-

(a)   The means enabling the oxygen to be introduced is disposed at the periphery of the chamber,

(b)   The means enabling the oxygen to be introduced is disposed at a position intermediate the periphery of the chamber and the source,

(c)   The means enabling the oxygen to be introduced is disposed at a position adjacent the source for the production of evaporated aluminium,

(d)   The means enabling the oxygen to be introduced comprises more than one inlet,

(e)   The inlets comprising the means of (d) are spaced around the periphery of the chamber,

(f)   One of the inlets of (d) is disposed at the periphery of the chamber and the remainder of them elsewhere in the chamber,

(g)   The or each oxygen inlet comprises a control valve.

According to another aspect of the present invention, there is provided a method of metallising a length of material including the steps of passing the length of material to be metallised under vacuum conditions over a source of evaporated alumium in a vacuum chamber whilst simultaneously introducing oxygen to the chamber in order to modify at least the normal silver surface appearance of the metal coating of the material so produced.

According to a still further aspect of the present invention, there is provided a web metallised with aluminium, the aluminium being oxidised on at least one surface in order to produce a surface appearance other than silver.

In order that the invention may be more clearly understood, one embodiment thereof will now be

-4-

described, by way of example, with reference to the accompanying drawings, in which:-

Figure 1 shows a front elevational view in section of a vacuum web metallising apparatus,

Figure 2 shows a partial diagrammatic view of the metalliser of Figure 1 illustrating a modification,

Figure 3 shows a partial diagrammatic view of the metalliser of Figure 1 illustrating a further modification,

Figure 3a is a plan view of part of the metalliser of Figure 3,

Figure 4 shows a partial diagrammatic view of the metalliser of Figure 1, illustrating a still further modification, and

Figure 5 shows a graph of vacuum chamber pressure plotted against oxygen flow rate for a vacuum web metallising apparatus.

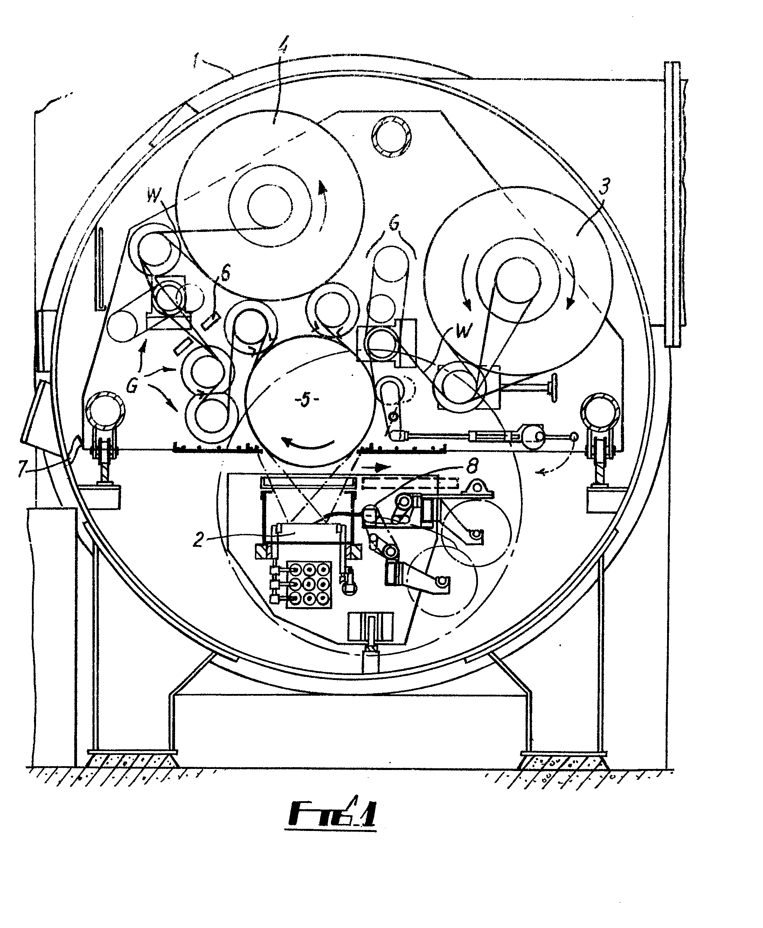

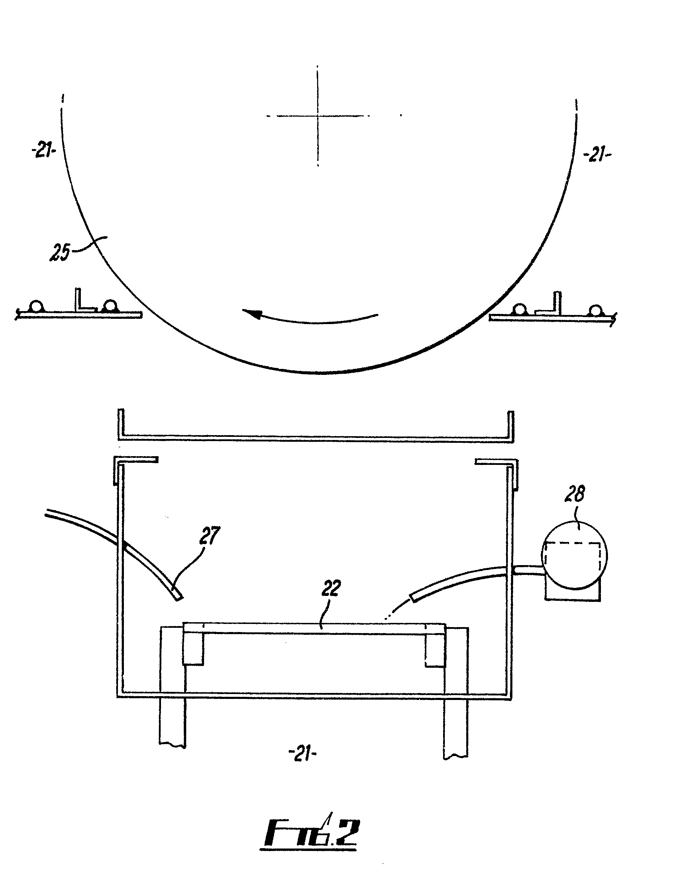

In Figures 2 to 5 parts equivalent to those
of the metalliser of Figure 1 have been given the
same reference numerals but prefixed by the number
of the figure in question.

Referring to Figure 1 of the drawings, the
web metallising apparatus comprises a vacuum chamber
1 housing an aluminium vapour source 2 comprising
nine individual boats each 10" long, a pay off
or supply reel 3, a driven take-up reel 4 and a
driven water cooled process drum 5.  The web (referenced W in Figure 1) follows  a complex path
defined by a series of guide rolls in conjunction
with the surface of drum 5 from the supply reel
3 to the take-up reel 4.  The guide rolls are
indicated generally by the reference G in Figure
1.  An inlet 7 incorporating a needle valve is disposed in the periphery of the vacuum chamber 1.  This
inlet 7 enables a gas such as oxygen to be introduced into the chamber 1 during the metallising
process.  A monitor 6 is disposed between the
source 2 and the take-up reel 4 and a closed loop
control system (not shown) is associated with
this monitor 6.

In operation, unmetallised web is fed from the supply reel 3 and is cooled as it passes over the
working surface of the water cooled drum 5. The web
is a 12 micron thick 1000 mm wide transparent
polyester film such as that marketed under the
trade mark Mellinex. Aluminium wire is fed from
a wire feed 8 to the vapour source 32. Oxygen is
simultaneously introduced into the chamber 1 through
the needle valve of the inlet 7. The amount of
oxygen admitted is such as to reduce the vacuum
in the vacuum chamber from a usual $5 \times 10^{-4}$ Torr
to $7 \times 10^{-3}$ Torr. The oxygen is allowed to flood
the entire interior of the vacuum chamber with no
deliberate attempt being made to distribute it
within the chamber. As the web passes over the
working surface of the drum 5 a cloud of metal
vapour condenses on the surface of the web facing the
source 2 in the surrounding oxygen atmosphere. The
oxygen modifies at least the normal silver surface
appearance of the coating on the web to produce
colouration and other optical effects. The monitor
and associated control system ensures that the coating thickness is kept at a chosen nominal thickness
and with a chosen tolerance.

The surface appearance and other optical effects
achieved may be varied by varying physical parameters
of the metallising process. Table 1 shows surface

-7-

appearance and other optical effects achived for various values of web speed, aluminium wire feed, chamber pressure, oxygen flow rate and resultant web resistivity. The colour visible on the underside of the web is in fact the colour of the underside of the metallising layer which can be seen through the transparent film constituting the web. It will therefore be appreciated that the constitution of the metallising layer varies from the under to the upper surface affecting the colour displayed.

Surface appearance and other optical effects may also be varied by varying the position at which the oxygen is introduced into the vacuum chamber. Table 2 shows the surface appearance and other optical effects achieved with oxygen introduced through an inlet 27 incorporating a needle valve disposed adjacent one end and above the aluminium vapour source 22 as shown in Figure 2. One test was conducted with the needle valve fully open and with no oxygen flow control equipment fitted. Although a considerable quantity of oxygen was introduced in this test into the bottom of the aluminium vapour source there was a negligible increase in chamber pressure.

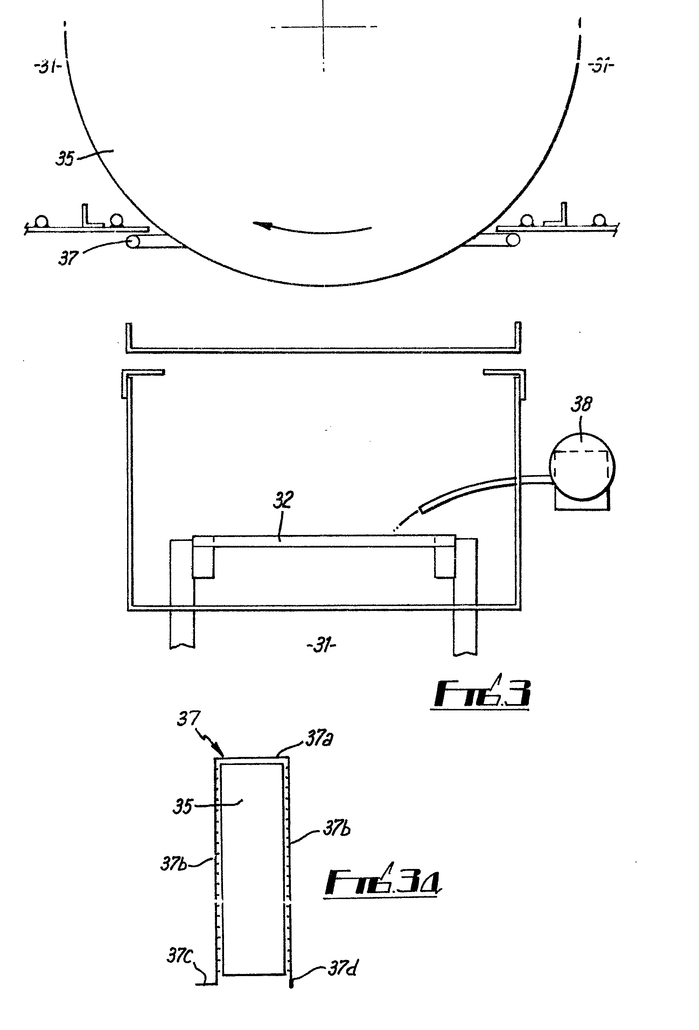

Table 3 shows the surface appearance and other optical effects achieved with oxygen introduced into the vacuum chamber 31 through an inlet manifold 37 disposed above the boats of the aluminium vapour source 32 but closely adjacent the surface of the process drum 35 as shown in Figure 3. The manifold 37, which is shown in plan view in Figure 3a, is made from ½" diameter pipe 37a provided with 17 holes 37b each of 1mm diameter and arranged at a 2½" pitch. The inlet to the manifold is referenced 37c and the other end 37c is blanked off. Apart from the greater range of colours achieved than with the arrangement of Figure 2, the Figure 3 mode of oxygen introduction may cause less deterioration to the boats of the vapour source than with the Figure 2 mode. It was also possible to produce effects with this mode attributable to the individual oxygen jet emanating from the holes of the manifold.

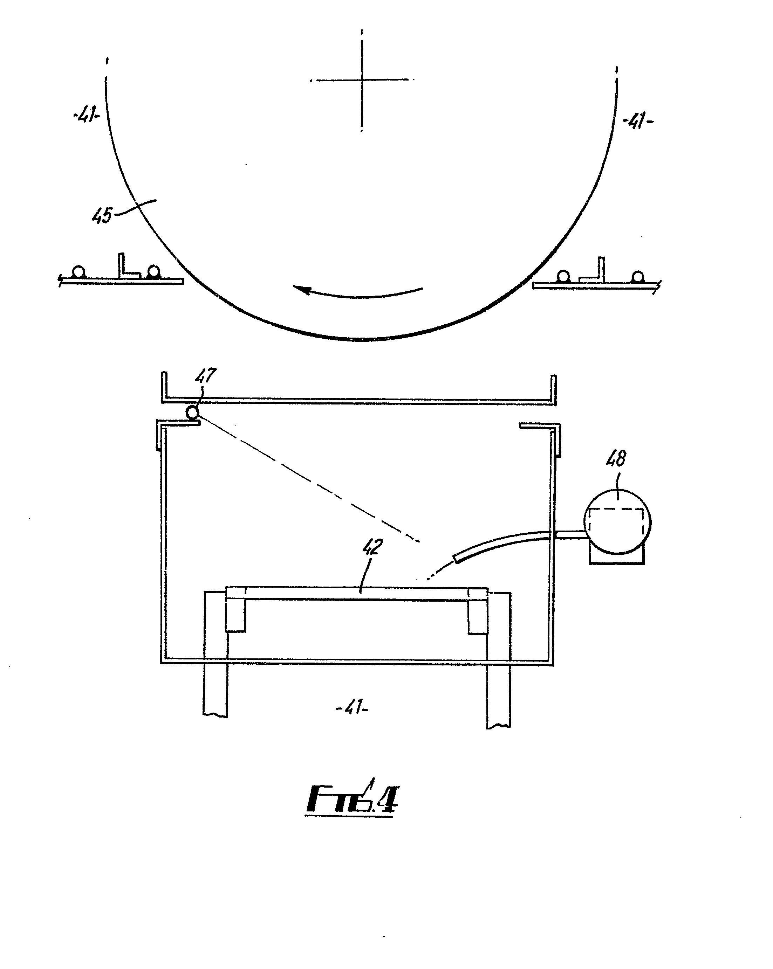

Table 4 shows the surface appearance and other optical effects achieved with oxygen introduced into the vacuum chamber 41 through a manifold 47 disposed above the vapour source 42 and between that source 42 and the process drum 45 as shown in Figure 4. This manifold 47 runs the full length of the vapour source 42, an inlet at one end and is blanked off at the other, and comprises 34 holes each 2mm in diameter and disposed at a pitch of $1\frac{1}{4}$".

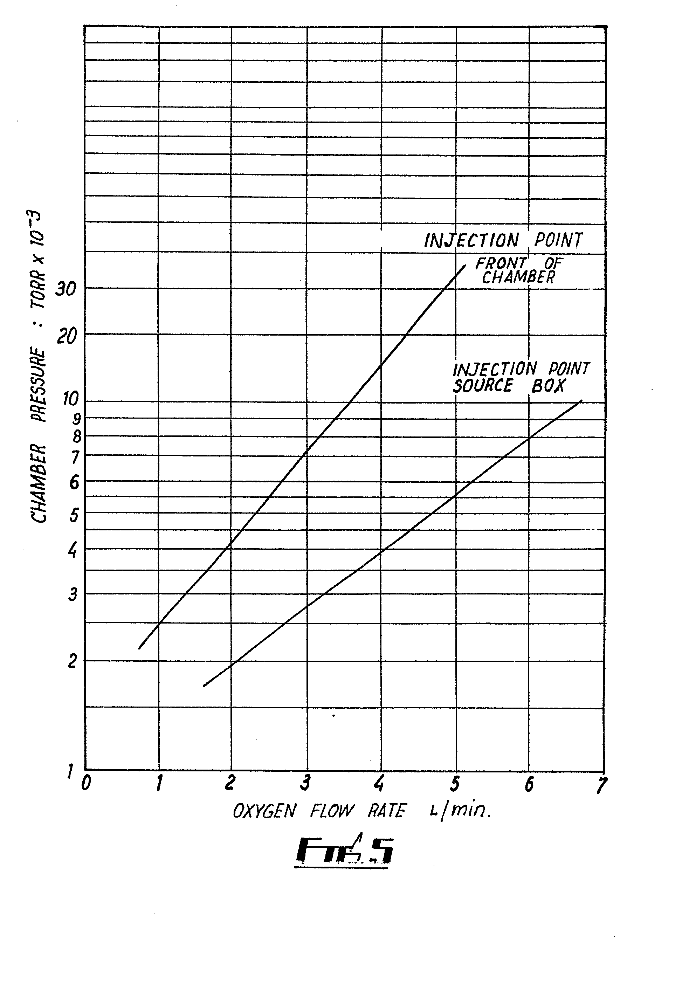

Figure 5 is a graphical representation of the variation of chamber pressure with oxygen flow rate for oxygen injection at the front of the chamber (as in Figure 1) and for oxygen injection into the vapour source box (as in Figure 4). These results were obtained with the Applicants Type sers. 1000D vacuum metalliser and different results would be obtained from other metallisers.

It will be appreciated that the above embodiments have been described by way of example only and that many variations are possible without departing from the scope of the invention claimed. For example greater control of oxygen flow rate may be employed and oxygen injection may be at several different points at the periphery of the chamber. Also, the description refers to single sided metallisers, but the invention is equally applicable to double sided metallisers where both surfaces of the web could be given a modified appearance. The invention would also be applied to metallising processes where more than one coating is applied to at least one side of the web. The web could be pretreated and if more than one coating is applied not all the coatings need to be modified. The coated web could be treated after coating if desired.

TABLE 1. Results of Test with Oxygen Injected at front of Vacuum Chamber Mode 1.

| Web. Speed ft/min. | Wire Feed in/min. | Chamber Pressure Torr. | Oxygen Flow Rate L/min. | Resistance Ohms/Sq. | Surface appearance other optical effects |
|---|---|---|---|---|---|
| 1000 | 35 | $4 \times 10^{-4}$ | Zero | 2.6 to 3.2 | Normal silver both sides. |
| 1000 | 35 | $1 \times 10^{-3}$ | <1 | 3.7 to 4.3 | Normal silver both sides. |
| 1000 | 35 | $3 \times 10^{-3}$ | <1 | 2.3 to 2.4 | Normal silver both sides. |
| 1000 | 35 | $5 \times 10^{-3}$ | 2.2 | 2.2 to 2.7 | Normal silver both sides. |
| 1000 | 35 | $12 \times 10^{-3}$ | 3.0 | 1.8 to 2.0 | Normal silver both sides. |
| 1000 | 35 | $25 \times 10^{-3}$ | 4.25 | 2.3 to 3.0 | Normal silver both sides. |
| 200 | 64 | $3.5 \times 10^{-4}$ | Zero | 0.15 to 0.16 | Normal silver both sides. |
| 200 | 64 | $1 \times 10^{-3}$ | <1 | 0.2 to 0.25 | Gold on metallised side, silver on underside. |
| 200 | 64 | $3.5 \times 10^{-3}$ | 1.8 | 0.2 to 0.27 | Gold on metallised side, silver on underside. |
| 200 | 64 | $5 \times 10^{-3}$ | 2.4 | 0.24 to 0.29 | Gold on metallised side, silver on underside. |
| 200 | 64 | $6 \times 10^{-3}$ | 2.8 | 0.3 to 0.35 | Gold on metallised side, slight browning of edges, silver underside. |
| 200 | 64 | $10 \times 10^{-3}$ | 3.6 | 0.34 to 0.45 | Gold/brown with purpled edges, silver underside. |
| 200 | 64 | $25 \times 10^{-3}$ | 4.4 | 0.60 to 0.68 | Brown, edges discoloured, silver underside. |

0082001

TABLE 2. Results of Test with Oxygen Injected through
a single Outlet in Bottom of Source Box Mode 2.

| Web speed ft/min. | Wire feed in/min. | Chamber Pressure Torr. | Oxygen Supply | Resistance Ohms/sq. | Surface appearance and other optical effects. |
|---|---|---|---|---|---|
| 200 | 68 | $8 \times 10^{-4}$ | OFF | 0.25 | Normal silver both sides. |
| 200 | 68 | 6 to 7 $\times 10^{-4}$ | ON | 0.25 on edge of film. | Transparent coating also achieved during this test. |
| | | | | 12 in. black band was 1 to 650 Ohms/sq. | About 12 inch band of black coating local to injection point. Underside silver. |

TABLE 3. Results of Test with Oxygen Injected through Manifold
Pipe along both sides of the Process Drum Mode 3.

| Web Speed ft/min. | Wire Feed in/min. | Chamber Pressure Torr. | Oxygen supply | Resistance Ohms/sq. | Surface appearance and optical effects. |
|---|---|---|---|---|---|
| 200 | 68 | $5 \times 10^{-4}$ | OFF | 0.2 | Normal silver both sides. |
| 200 to 300 | 68 | Varied over range $1.3$ to $4 \times 10^{-3}$ | ON | 1 to 2 | Various colours obtained dark blue, bronze, mauve, purple and gold. Underside silver. |

-13-

TABLE 4. Results of Test with Oxygen Inject through a single manifold situated along one edge of source box Mode 4.

| Web Speed ft/min. | Wire Feed in/min. | Chamber Pressure Torr. | Oxygen Supply L/min. | Resistance Ohms/sq. | Optical Denisity | Surface appearance and other optical effects. |
|---|---|---|---|---|---|---|
| 200 | 68 | $8 \times 10^{-4}$ | Zero | 0.15 | 1.0 | Normal silver both sides. |
| 200 | 68 | $3 \times 10^{-3}$ | 3.2 | 7 to 42 | 0.46 | Gold reflective coating semi-transparent to transparent. Underside dark silver. |
| 1000 | 42 | $8 \times 10^{-4}$ | Zero | 0.2 to 0.4 | Opaque | Normal silver both sides. |
| | | $3 \times 10^{-3}$ to $6.5 \times 10^{-3}$ | 3.2 to 5.4 | 0.2 to 0.4 | Opaque | Gold on top side silver underside. |
| | | | | 0.4 to 0.6 | Opaque | Purple, bronze, silver underside. |
| | | | | 0.5 to 0.7 | Opaque | Dark blue, silver underside. |
| | | | | 0.6 to 5 | Opaque | Black/dark green, silver underside. |

-15-

CLAIMS

1. Apparatus for metallising a length (W) of material comprising a vacuum chamber (1) housing supply means (3) for the supply of the length of material to be metallised, a source (2) for the production of evaporated aluminium and take-up means (4) for receiving the length of metallised material, characterised in that the vacuum chamber is provided with means (7) enabling oxygen to be introduced thereto during the metallising process.

2. Apparatus as claimed in claim 1, in which the means (7) enabling the oxygen to be introduced is disposed at the periphery of the chamber.

3. Apparatus as claimed in claim 1, in which the means (7) enabling the oxygen to ' be introduced is disposed at a position intermediate the periphery of the chamber and the source.

4. Apparatus as claimed in claim 1, in which the means (7) enabling the oxygen to be introduced is disposed at a position adjacent the source for the production of evaporated aluminium.

5.    Apparatus as claimed in claim 1, in which the means (7) enabling the oxygen to be introduced comprises more than one inlet.

6.    Apparatus as claimed in claim 5, in which the inlets are spaced around the periphery of the chamber.

7.    Apparatus as claimed in claim 5, in which one of the inlets is disposed at the periphery of the chamber (1) and the remainder of them elsewhere in the chamber.

8.    Apparatus as claimed in claim 5, 6, or 7, in which the or each oxygen inlet (7) comprises a control valve.

9.    A method of metallising a length of material including the steps of passing the length (W) of material to be metallised under vacuum conditions over a source (2) of evaporated aluminium in a vacuum chamber (1) whilst simultanteously introducing oxygen to the chamber (1) in order to modify at least the normal silver surface appearance of the metal coating of the material so produced.

10. A method as claimed in claim 9, in which oxygen is introduced at the periphery of the chamber (1).

11. A method as claimed in Claim 10, in which oxygen is introduced at a position (37) intermediate the periphery of the chamber (1) and the source (2).

12. A method as claimed in claim 10, in which oxygen is introduced at a position (27) adjacent the source (2).

13. A method as claimed in claim 10, in which the oxygen is introduced to the chamber (1) through a plurality of inlets (37b).

14. A method as claimed in Claim 10, in which oxygen is introduced through a plurality of inlets spaced around the periphery of the chamber (1).

15. A method as claimed in Claim 10, in which the oxygen is introduced through a plurality of inlets one of which is disposed at the periphery of and the others elsewhere in the chamber (1).

16. A method as claimed in Claim 13, in which the introduction of oxygen is controlled by valve means.

17. A web metallised with aluminium, the aluminium being oxidised on at least one surface in order to produce a surface appearance other than silver.

1/5

**FIG.1**

-21-  -21-

25

27

22

28

-21-

**Fig.2**

3/5

-31-

35

37

-31-

38

32

_Fig.3_

37

37a

35

37b

37b

37b

_Fig.3a_

37c

37d

Fig.4

CHAMBER PRESSURE : TORR x 10$^{-3}$

INJECTION POINT
FRONT OF CHAMBER

INJECTION POINT
SOURCE BOX

OXYGEN FLOW RATE L/min.

Fig.5

# 0082001

<table>
<tr><td colspan="2">European Patent Office</td><td>EUROPEAN SEARCH REPORT</td><td>Application number</td></tr>
</table>

| | DOCUMENTS CONSIDERED TO BE RELEVANT | | EP 82306627.9 |

| Category | Citation of document with indication, where appropriate, of relevant passages | Relevant to claim | CLASSIFICATION OF THE APPLICATION (Int. Cl. ³) |
|---|---|---|---|
| P,X | EP - A2 - 0 048 884 (MATSUSHITA ELECTRIC INDUSTRIAL CO., LTD.) <br><br> * Totality, especially fig.; claims * | 1-16 | C 23 C 13/08 <br> C 23 C 13/10 <br> C 23 C 13/02 |
| X | PATENT ABSTRACTS OF JAPAN, unexamined applications, field C, vol. 6, no. 49, March 31, 1982 <br> THE PATENT OFFICE JAPANESE GOVERNMENT, <br> page 58 C 96 <br><br> * Kokai-no. 56-163262 (NIPPON SHINKU GIJUTSU K.K.) * | 1,2,9, 10 | |
| A | PATENT ABSTRACTS OF JAPAN, unexamined applications, field C, vol. 6, no. 15, January 28, 1982 <br> THE PATENT OFFICE JAPANESE GOVERNMENT, <br> page 141 C 89 <br><br> * Kokai-no. 56-139674 (SHIMAZU SEISAKUSHO K.K.) * | 1 | TECHNICAL FIELDS SEARCHED (Int. Cl. ³) <br><br> C 23 C <br> B 05 B <br> B 05 D |
| A | PATENT ABSTRACTS OF JAPAN, unexamined applications, field C, vol. 5, no. 188, November 27, 1981 <br> THE PATENT OFFICE JAPANESE GOVERNMENT, <br> page 103 C 81 <br><br> * Kokai-no. 56-112471 (TOKYO SHIBAURA DENKI K.K.) * | 1 | |

The present search report has been drawn up for all claims

| Place of search | Date of completion of the search | Examiner |
|---|---|---|
| VIENNA | 21-02-1983 | SLAMA |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82

**European Patent Office**

**EUROPEAN SEARCH REPORT**

EP 82306627.9

| DOCUMENTS CONSIDERED TO BE RELEVANT | | | CLASSIFICATION OF THE APPLICATION (Int. Cl. ³) |
|---|---|---|---|
| Category | Citation of document with indication, where appropriate, of relevant passages | Relevant to claim | |
| A | PATENT ABSTRACTS OF JAPAN, unexamined applications, field C, vol. 4, no. 7, January 19, 1980<br><br>THE PATENT OFFICE JAPANESE GOVERNMENT,<br>page 44 C 70<br><br>    * Kokai-no. 54-141393 (MATSUSHITA DENKI SANGYO K.K.) *<br><br>-- | 1 | |
| A | PATENTS ABSTRACTS OF JAPAN, unexamined applications, section C, vol. 3, no. 55, May 11, 1979<br><br>THE PATENT OFFICE JAPANESE GOVERNMENT,<br>page 38 C 45<br><br>    * Kokai-no. 54-28782 (FUJI SHASHIN FILM K.K.) *<br><br>-- | 1 | TECHNICAL FIELDS SEARCHED (Int. Cl. ³) |
| A | PATENTS ABSTRACTS OF JAPAN, unexamined applications, section C, vol. 3, no. 32, March 17, 1979<br><br>THE PATENT OFFICE JAPANESE GOVERNMENT,<br>page 81 C 40<br><br>    * Kokai-no. 54-6878 (FUJI SHASHIN FILM K.K.) *<br><br>---- | 1 | |